Europäisches Patentamt

European Patent Office

Office européen des brevets

(11) Publication number: **0 031 681**
**B1**

(12) **EUROPEAN PATENT SPECIFICATION**

(45) Date of publication of patent specification: **10.04.85**

(51) Int. Cl.⁴: **G 11 C 11/40**

(21) Application number: **80304586.3**

(22) Date of filing: **18.12.80**

(54) Decoder circuit.

(30) Priority: **27.12.79 JP 169186/79**

(43) Date of publication of application:
**08.07.81 Bulletin 81/27**

(45) Publication of the grant of the patent:
**10.04.85 Bulletin 85/15**

(84) Designated Contracting States:
**DE FR GB NL**

(56) References cited:
**US-A-3 588 672**
**US-A-4 164 791**

**IBM TECHNICAL DISCLOSURE BULLETIN, vol.
20, no. 12, May 1978, NEW YORK (US),
MARCELLO et al.: "Current switch bit line
driver", pages 5188-5189
FREQUENZ, vol. 29, no. 3, March 1975, BERLIN
(DE), GLOCK et al.: "Schnelle
Halbleiterspeicher in Bipolartechnik", pages
80-87**

(73) Proprietor: **FUJITSU LIMITED**
**1015, Kamikodanaka Nakahara-ku
Kawasaki-shi Kanagawa 211 (JP)**

(72) Inventor: **Tanaka, Miki**
**1380, Kamikodanaka Nakahara-ku
Kawasaki-shi Kanagawa 211 (JP)**
Inventor: **Isogai, Hideaki**
**11-13, Minamisawa 4-chome
Higashikurume-shi Tokyo 180-03 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

The present invention relates generally to decoder circuits and more particularly, but not exclusively, to a decoder circuit which is suitable for use for memory cell selection in a memory device.

Generally, a memory device mainly comprises a plurality of word lines and bit lines arranged in matrix form, a plurality of memory cells provided at respective intersection points between the word lines and bit lines, a decoder circuit for performing word line selection, and a decoder circuit for performing bit line selection. The present invention is applicable to one or both of these types of decoder circuit. Conventionally, in a memory device of the above type, a constant current source circuit which flows bit current to the bit line group and a switching circuit which flows the bit current to only the bit line which is to be selected, are respectively, separately and independently connected in series in a bit line selection decoder circuit. Accordingly, at least two stages of voltage boosting are required for the transistors which form the constant current source circuit and switching circuit, resulting in the incapability of obtaining low-level biasing. Hence, the margin of allowable variation in the power source output level becomes small, and results in a disadvantage in that stable operation of the memory system cannot be guaranteed.

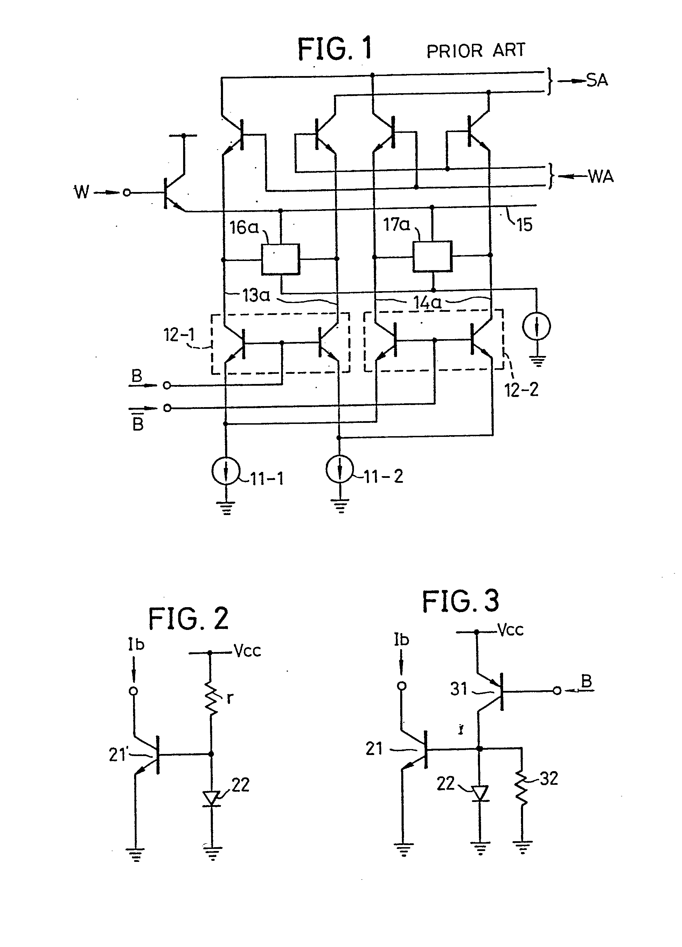

Frequenz, Vol 29, No. 3, March 1975, pages 80 to 87, in an article by Glock and Ernst, entitled "Schnelle Halbleiterspeicher in Bipolartechnik", discloses (Fig. 8) a decoder circuit having an arrangement of switching circuits and current supply transistors $(T_3, T_4)$ generally similar to that of Fig. 1 of the present application described below.

US—A—4 164 791 discloses (Fig. 1) a decoder circuit in which constant current sources are connected to respective bit lines. Switching circuits $(Q_{Y00}, Q_{Y01}; Q_{Y10}, Q_{Y11})$ are provided which are operable in dependence upon control signals. The switching circuits are connected to bit lines, but outside the bit lines, so that for selected bit lines current from constant current sources flows in the lines, whilst for non-selected bit lines current from constant current sources flows through the connected switching circuits to ground.

In Fig. 1 of the present application, as shown in Fig. 2, constant current source circuits have respective transistors the collector of each of which is connected to lines from more than one line system.

According to the present invention there is provided a decoder circuit comprising:

a plurality of switching circuits operable in dependence upon control signals to switch a selected connection to a potential thereby to provide a signal to activate one or more selected lines of a plurality of line systems; and

constant current supply circuits, for supplying constant current to said selected lines, having respective transistors of which the collectors are connected to respective lines of the line system, each said transistor having its base connected to the respective one of said switching circuits for turning the transistor on and off, characterised in that

each said transistor has its emitter directly connected to a terminal of a power source, whereby low-level biasing is obtained.

The decoder circuit preferably comprises a differential amplifier circuit for producing said control signals in dependence upon one or a plurality of line selection signals to be decoded.

According to one development each switching circuit comprises a PNP-transistor having its emitter connected to a power source terminal, its collector connected to one terminal of a resistor, and its base arranged to receive one of said control signals, said resistor being connected to ground at its other terminal, and each constant current supply circuit comprises an NPN-transistor having its collector connected to a line of one of said line systems, its base connected to the collector of the PNP-transistor in one of said switching circuits, as well as to ground through a diode, and its emitter being grounded, said diode being connected with its forward direction towards ground.

According to one possibility said control signals are bit line selection signals, said line systems are bit line systems, and said lines of said line systems are bit lines within a memory device, said decoder circuit being operable for bit line selection within said memory device.

According to another possibility said control signals are word line selection signals, said line systems are word line systems, and said lines of said line systems are word lines within a memory device, said decoder circuit being operable for word line selection within said memory device.

A preferred embodiment of the present invention provides a novel and useful decoder circuit in which the previously described problems are overcome.

Other objects and further features of a preferred embodiment of the present invention will be apparent from the following detailed description when read in conjunction with the accompanying drawings.

Fig. 1 is a circuit diagram showing an example of a memory device having a conventional decoder circuit;

Fig. 2 is a circuit diagram showing the construction of a conventional constant current source circuit of Fig. 1;

Fig. 3 is a circuit diagram showing the main construction of an embodiment of a decoder circuit according to the present invention;

Fig. 4 is a circuit diagram showing an embodiment of a memory device having a decoder circuit according to the present invention; and

Fig. 5 is a circuit diagram showing another embodiment of a memory device having a decoder circuit according to the present invention.

Fig. 1 shows a circuit diagram of a memory device having a conventional decoder circuit. Thus in Fig. 1, a bit line selection decoder circuit comprises constant current source circuits 11-1 and 11-2, and switching circuits 12-1 and 12-2 which respectively receive bit selection inputs B and $\bar{B}$. The lines subjected to the decoding by the above bit line selection decoding circuit, are bit lines 13a and 14a. A word line 15 runs across these bit lines 13a and 14a, and memory cells 16a and 17a are arranged and provided at each of the intersection points. A sense amplifier and write-in address are respectively designated by SA and WA. There are, of course, a plurality of word lines 15 and memory cells 16a and 17a, however, only a part of the memory device is shown in Fig. 1. ,

In the decoder circuit in the memory device of Fig. 1, the constant current source circuits (11-1 and 11-2) and the switching circuits (12-1 and 12-2), respectively, are independently connected in series, and therefore, voltage is boosted at the transistors forming each of the circuits; that is, the voltage is boosted at least by the amount of the base-emitter voltage in the forward direction of the transistors for the two stages. Accordingly, low-level biasing cannot be obtained, and results in the introduction of the aforementioned problem in which the margin of variance in the power source output level becomes small.

In accordance with the present invention, the switching circuits 12-1 and 12-2 shown in Fig. 1 are rearranged to provide low-level biasing.

The construction of a constant current source circuit of Fig. 1 is shown in Fig. 2. In Fig. 2, an NPN-transistor 21 is a transistor which flows a bit current Ib through a bit line. The above current source circuit of Fig. 2 is of a so-called current mirror type, in which a diode 22 is connected to the base of the transistor 21 as the diode formed by the base-emitting junction. Furthermore, a base resistance and a voltage source are respectively designated by r and Vcc.

Fig. 3 shows part of an embodiment of a decoder circuit of the present invention. As clearly seen in Fig. 3, a PNP-transistor 31 and a pull-down resistor 32 are inserted and connected in parallel with respect to the transistor 21 and diode 22. When a bit selection input $\bar{B}$ which is of low level is applied to the base of the transistor 31, the transistor 31 is turned ON. The transistor 21 is also turned ON due to the voltage Vcc applied to the base of the transistor 21, and accordingly flows a bit current 1b through the associated bit line.

On the other hand, when a selected input B which is of high level is applied to the base of the PNP-transistor 31, the transistor 31 is turned OFF. Accordingly, the base voltage of the transistor 21 becomes of ground potential through the pull-down resistor 32, and the transistor 21 is turned OFF. This means that the bit current 1b is switched according to the selection input B or $\bar{B}$. It must be noted that the switching circuits (31 and 32) in the circuit of the present embodiment differ from the conventional switching circuits (12-1 and 12-2) in that they are positioned outside of the group of bit lines. Therefore, the biasing level of the bit lines is approximately 0.8 volts each, which corresponds at the most to the reverse voltage of the diode 22, and low-level biasing can thus be obtained. Moreover, the margin of variation in the power source output level is increased.

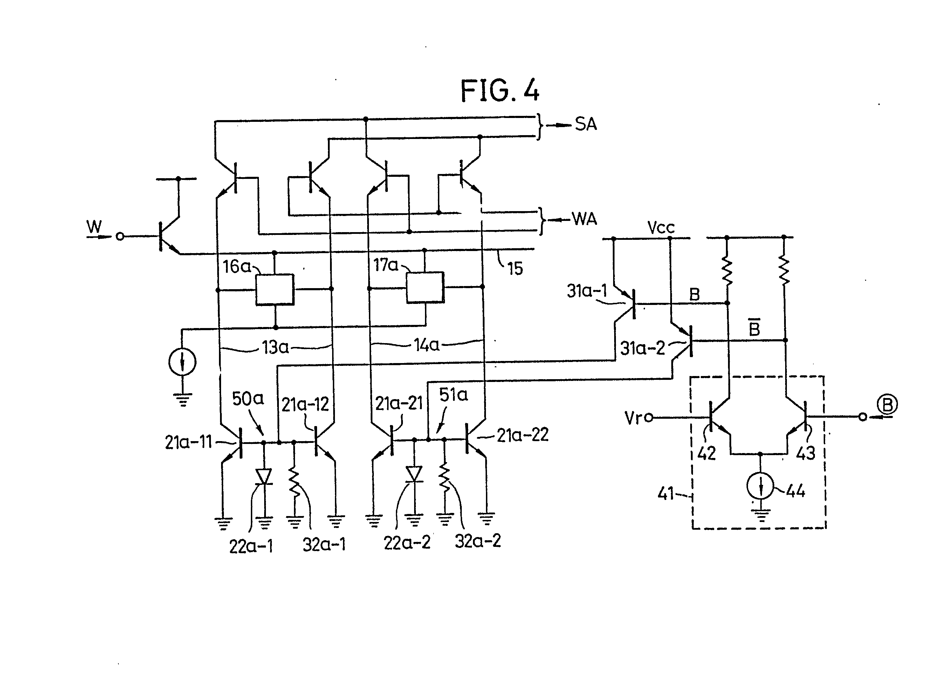

Fig. 4 is a circuit diagram showing one embodiment of a memory device comprising a decoder circuit according to the present invention. In Fig. 4, those parts which are the same as those corresponding parts in Fig. 1 are designated by the same reference numerals, and their description will be omitted. Here, NPN-transistors 21a-11, 21a-12, 21a-21, and 21a-22, and diodes 21a-1 and 21a-2, are comprised in the above constant current source circuit part. In addition to these elements, PNP-transistors 31a-1 and 31a-2, resistors 32a-1 and 32a-2 are provided as shown in Fig. 4. A differential amplifier 41 which applies the bit selection inputs B and $\bar{B}$ to these transistors 31a-1 and 31a-2, comprises an NPN-transistor 42 which has a standard voltage Vr as its input, an NPN-transistor 43 which has a bit selection signal (B) to be decoded as its input, and a constant current source circuit 44.

The differential amplifier 41 is of a known construction, and is a part of the circuit which should produce the bit selection inputs B and $\bar{B}$ of Fig. 1 as outputs. If the bit selection signal (B) is of high level, for example, the transistor 43 is turned ON and the transistor 42 is turned OFF. Accordingly, the bit selection input B becomes of high level (the bit selection input $\bar{B}$ becomes of low level), turning the transistor 31a-1 OFF, and selects a bit system 51a (bit system 50a is put in a non-selected state) so that bit lines 14a are activated. Similarly, when the bit selection signal (B) is of low level, the bit system 50a is then selected so that bit lines 13a are activated, and the bit system 51a is put in a non-selected state.

The embodiment of Fig. 4 shows a case in which there are two-bit inputs B and $\bar{B}$, however, this can be expanded into a four-bit input type, for example. In this modified case, only the construction of the differential amplifier 41 of Fig. 4 is changed.

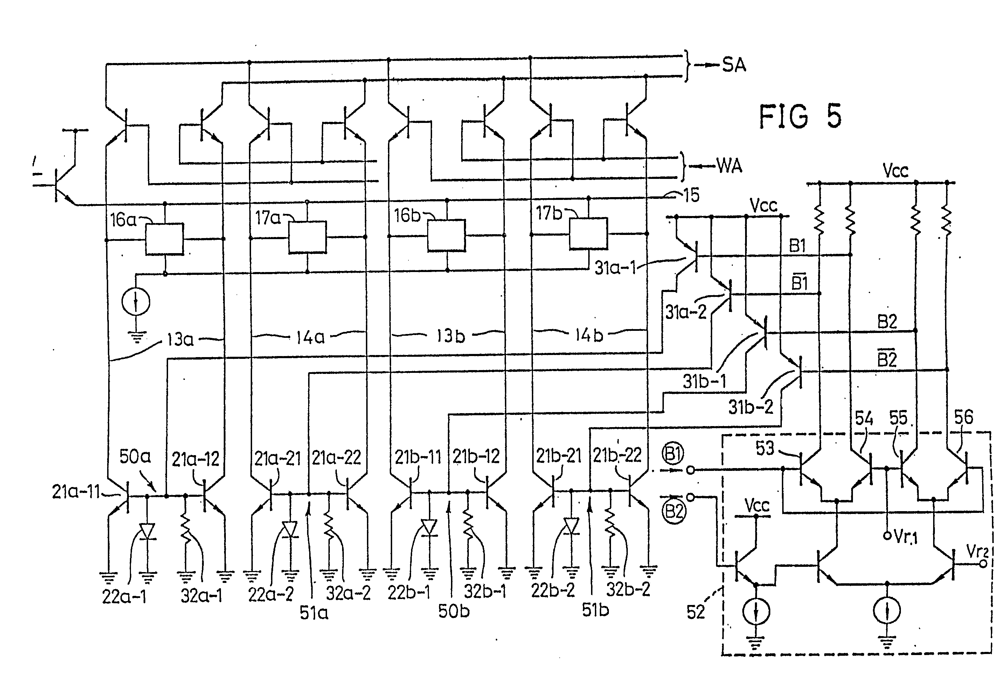

The above modified case is shown in Fig. 5. In Fig. 5, those parts which are the same as those corresponding parts in Fig. 4 are designated by the same reference numerals, and their description will be omitted.

Those parts having a numeral with subscript "b", have the same construction and function as those corresponding parts having the same numeral with subscript "a' of Fig. 4. A known four-bit input differential amplifier 52 is used in this case, and the bit selection signals to be decoded are designated by (B1) and (B2). Similarly as in the case of the differential amplifier 41 of Fig. 4, when the bit selection signal B1 is of high level, for example an NPN-transistor 53 is turned ON and an NPN-transistor 54 is turned OFF. Accordingly, a bit selection input $\overline{B1}$ becomes of high level (the bit selection input $\overline{\overline{B1}}$

becomes of low level), turning the transistor 31a-1 OFF, and selects the bit system 51a (the bit system 50a is put in a non-selected state) so that bit lines 14a are activated. Moreover, when the bit selection signal B1 is of low level, the bit system 50a is then selected so that bit lines 13a are activated, and the bit system 51a is put in a non-selected state. By similar procedures, bit systems 50b and 51b can be selected so that bit lines 13b and 14b respectively are activated, according to the level of the bit selection signal (B2) Furthermore, by the logical combination of these bit selection signals (B1) and (B2), one of the four-bit inputs B1, $\overline{B1}$ B2, or $\overline{B2}$ is always of low level, and thus selects one of the corresponding bit.systems from the bit systems 50a, 51a, 50b, or 51b. These logic combinations are shown in the following table, in which "H" and "L" respectively indicate high and low levels.

TABLE

| (B1) | (B2) | $\overline{B1}$ | B1 | B2 | $\overline{B2}$ |
|------|------|------|----|----|------|
| H | H | L | H | H | H |
| H | L | H | H | H | L |
| L | H | H | L | H | H |
| L | L | H | H | L | H |

Accordingly, a system having a high stability factor can be realized, since a decoder circuit which can be biased at low level is obtained, increasing the margin of variance in the output level of the power source within the system.

Further, this invention is not limited to these embodiments but various variations and modifications may be made without departing from the scope of the invention.

A decoder circuit comprises: a differential amplifier circuit 41 which receives one of a plurality of line selection signals (B) which are to be decoded; switching circuits 31a-1, 31a-2, for switching predetermined line systems 50a, 51a in high or low level states according to the output signal B, $\overline{B}$ supplied from the differential amplifier circuit 41, and constant current supply circuits 21, 22 for supplying constant current to predetermined lines 13a, 14a of the above line systems 50a, 51a according to the signal supplied from the switching circuits 31a-1, 31a-2.

The invention has been particularly described with reference to bit systems. However, it will be apparent to those skilled in the art that the invention is equally applicable to word systems.

**Claims**

1. A decoder circuit comprising:
a plurality of switching circuits operable in dependence upon control signals (B) to switch a selected connection to a potential thereby to provide a signal to activate one or more selected lines of a plurality of line systems; and
constant current supply circuits, for supplying constant current to said selected lines, having respective transistors (21) of which the collectors are connected to respective lines of the line systems, each said transistor having its base connected to the respective one of said switching circuits for turning the transistor on and off, characterised in that
each said transistor has its emitter directly connected to a terminal of a power source, whereby low-level biasing is obtained.

2. A decoder circuit according to claim 1, and comprising a differential amplifier circuit (41) for producing said control signals in dependence upon one or a plurality of line selection signals ((B)) to be decoded.

3. A decoder circuit according to claim 1 or 2, in which each switching circuit comprises a PNP-transistor (31) havings its emitter connected to a power source terminal (Vcc), its collector connected to one terminal of a resistor (32), and its base arranged to receive one of said control signals (B), said resistor being connected to ground at its other terminal, and in which the said respective transistors (21) of the constant current supply circuits are NPN-transistors each having its base connected to the collector of the PNP-transistor (31) in one of said switching circuits, as well as to ground through a diode (22), and its emitter being grounded, said diode being connected with its forward direction towards ground.

4. A decoder circuit according to any one of the preceding claims, in which said control signals are bit line selection signals, said line systems are bit line systems, and said lines of said line systems are bit lines within a memory device, said decoder circuit being operable for bit line selection within said memory device.

5. A decoder circuit according to any one of claims 1 to 3, in which said control signals are word line selection signals, said line systems are word line systems, and said lines of said line systems are word lines within a memory device, said decoder circuit being operable for word line selection within said memory device.

**Patentansprüche**

1. Dekodierschaltung mit:
einer Anzahl von Schaltkreisen, die in Abhängigkeit von Steuersignalen (B) betreibbar sind, um eine ausgewählte Verbindung zu einem Potential zu schalten, um dadurch ein Signal zu liefern, um eine oder mehrere Leitungen einer Anzahl von Leitungssystemen zu aktivieren, und Konstantstrom - Versorgungsschaltung zu Zuführen konstanten Stroms zu den genannten ausgewählten Leitungen, welche entsprechende Transistoren (21) haben, deren Kollektoren mit entsprechenden Leitungen des Leitungssystem verbunden sind wobei die Basis jedes Transistors mit einem entsprechenden der zugeordneten Schaltkreise verbunden ist um den Transistor einund auszuschalten, dadurch gekennzeichnet, daß der Emitter jedes genannten Transistors direkt mit einem Anschluß einer Energiequelle verbunden ist wodurch eine Vorspannung mit niederigem Pegel erreicht wird.

2. Dekodierschaltung nach Anspruch 1, gekennzeichnet durch eine Differenzialverstärkerschaltung (41) zur Erzeugung der genannten Steuersignale in Abhängigkeit von einem oder mehreren zu dekodierenden Leitungsauswahlsignalen (B).

3. Dekodierschaltung nach Anspruch 1 oder 2, bei welcher jeder Schaltkreis einen PNP Transistor (31) umfaßt, dessen Emitter mit einem Energiequellenanschluß (V$_{cc}$) verbunden ist dessen Kollektor mit einem Anschluß eines Widerstands (32) verbunden ist und dessen Basis so angeordnet ist, daß sie eines der genannten Steuersignale (B) empfängt, wobei der genannte Widerstand an seinem anderen Anschluß mit Erde Verbunden ist, und bei welcher die genannten jeweiligen Transistoren (21) der Konstantstrom Versorgungsschaltungen NPN-Transistoren sind, deren Basen jeweils mit dem Kollektor des PNP Transistors (31) in einem der genannten Schaltkreise verbunden sind, sowie auch über eine Diode (22) mit Erde und deren Emitter geerdet sind, wobei die genannte Diode in Vorwärtsrichtung mit Erde Verbunden ist.

4. Dekodierschaltung nach einem der vorhergehenden Ansprüche, bei welcher die genannten Steuersignale Bitleitungs-Auswahlsignale sind, die genannten Leitungssysteme Bitleitungssysteme sind und die genannten Leitungen der genannten Leitungssysteme Bitleitungen innerhalb einer Speichervorrichtung sind und die genannte Dekodierschaltung innerhalb der genannten Speichervorrichtung zur Bitleitungsauswahl betreibbar ist.

5. Dekodierschaltung nach einem der Ansprüche 1 bis 3, bei welcher die genannten Steuersignale Wortlietungs-Auswahlsignale, die genannten Leitungssysteme Wortleitungssysteme, die genannten Leitungen der genannten Leitungssysteme Wortleitungen innerhalb einer Speichervorrichtung sind und die Dekodierschaltung innerhalb der genannten Speichervorrichtung zur Wortleitungsauswahl betreibbar ist.

**Revendications**

1. Circuit de décodage comprenant:
plusieurs circuits de commutation ayant pour fonction, sous commande de signaux de commande (B), de commuter à un potentiel une connexion sélectionnée afin de produire un signal permettant d'activer une ou plusieurs lignes sélectionnées parmi plusieurs systèmes de lignes; et
des circuits d'alimentation en courant constant, servant à délivrer un courant constant auxdites lignes sélectionnées, qui comportent des transistors (21) respectifs dont les collecteurs sont connectés à des lignes respectives des systèmes de lignes, chaque dit transistor étant connecté par sa base à l'un, respectif, desdits circuits de commutation pour rendre le transistor conducteur et non conducteur,
caractérisé en ce que
chaque dit transistor est directement connecté par son émetteur à une borne d'une source d'alimentation électrique, si bien qu'une polarisation de niveau bas est obtenue.

2. Circuit de décodage selon la revendication 1, et comprenant un circuit amplificateur différentiel (41) qui produit lesdits signaux de commande en fonction d'un ou plusieurs signaux ((B)) de sélection de lignes à décoder.

3. Circuit de décodage selon la revendication 1 ou 2, dans lequel chaque circuit de commutation comprend un transistor PNP (31) dont l'émetteur est connecté à une borne (Vcc) d'une source d'alimentation électrique, dont le collecteur est connecté à une première borne d'une résistance (32), et dont la base est destinée à recevoir l'un desdits signaux de commande (B), ladite résistance étant connectée à la terre par son autre borne, et dans lequel lesdits transistors (21) respecifs des circuits d'alimentation en courant constant sont des transistors NPN qui sont chacun connectées par leur base au collecteur du transistor PNP (31) de l'un desdits circuits de commutation, ainsi qu'à la terre par l'intermédiaire d'une diode (22), tandis que leur émetteur est connecté à la terre, ladite diode étant connectée à la terre dans son sens passant.

4. Circuit de décodage selon l'une quelconque des revendications précédentes, dans lequel lesdits signaux de commande sont des signaux de sélection de lignes de bits, lesdits systèmes de bits sont des systèmes de lignes de bits, et lesdits lignes desdits systèmes de lignes sont des lignes de bits se trouvant à l'intérieur d'un dispositif de mémoire, ledit circuit de décodage ayant pour fonction de sélectionner des lignes de bits à l'intérieur dudit dispositif de mémoire.

5. Circuit de décodage selon l'une quelconque des revendication 1 à 3, dans lequel lesdits signaux de commande sont des signaux de sélection de lignes de mots, lesdits systèmes de lignes sont des systèmes de lignes de mots, et lesdits lignes desdits systèmes de lignes sont des lignes de mots se trouvant à l'intérieur d'un dispositif de mémoire, ledit circuit de décodage ayant pour fonction de sélectionner des lignes de mots à l'intérieur dudit dispositif de mémoire,

# FIG. 1    PRIOR ART

# FIG. 2

# FIG. 3

1

FIG. 4

2

FIG 5